# FASCICULE DE BREVET EUROPEEN

(11) **EP 0 703 460 B1**
(45) Date de publication et mention de la délivrance du brevet: **09.04.2003**
(21) Numéro de dépôt: 95410111.9
(22) Date de dépôt: 22.09.1995
(51) Int. Cl.: G01R 15/20

(54) **Capteur de courant à magnétorésistance**
Magnetoresistiver Strommesser
Magnetoresistive current sensor

(30) Priorité: 26.09.1994 FR 9411691
(43) Date de publication de la demande: 27.03.1996
(73) Titulaire: CROUZET Automatismes, 26000 Valence (FR)
(72) Inventeur: Blain, Gérard, F-26120 Chabeuil (FR); Ngoagouni, Olivier, F-01270 Coligny (FR)
(74) Mandataire: de Beaumont, Michel

(56) Documents cités:
- EP-A- 0 300 635
- EP-A- 0 315 358
- EP-A- 0 490 327
- EP-A- 0 539 081
- IEEE TRANSLATION JOURNAL ON MAGNETICS IN JAPAN, vol. 7, no. 5, Mai 1992 pages 413-417, XP 000291483 M.MATSUMOTO ET AL. 'application of mr element to clamp-on type current meter'

## Description

La présente invention concerne un capteur de courant. Elle s'applique plus particulièrement à la réalisation d'un microcapteur de courant dans lequel la mesure du courant qui circule dans un conducteur primaire est sans influence sur ce courant.

Une première méthode classique consiste à utiliser un système à bobinages pour effectuer la mesure du courant circulant dans un conducteur. Le courant à mesurer circule dans un enroulement primaire qui est associé à un enroulement secondaire traversé par un courant qui est mesuré. Le dispositif de mesure proprement dit est ainsi électriquement isolé du circuit primaire. Lorsqu'un courant circule dans l'enroulement primaire, ce courant créé un champ magnétique qui induit dans l'enroulement secondaire un courant proportionnel à la valeur du courant à mesurer (le rapport de proportionnalité dépend du rapport entre le nombre des spires que comportent les deux enroulements).

Un inconvénient d'un tel capteur à bobinages est qu'il présente un encombrement important par la présence des enroulements.

Une deuxième méthode classique consiste à utiliser des éléments dits magnétorésistifs dont une caractéristique est de présenter une résistivité qui varie en présence d'un champ magnétique. De tels éléments sont surtout connus pour des applications nécessitant une mesure d'un champ magnétique, par exemple, pour la détection de champ magnétique très faible ou dans des applications liées aux têtes de lectures magnétiques d'un disque dur ou aux billetteries magnétiques.

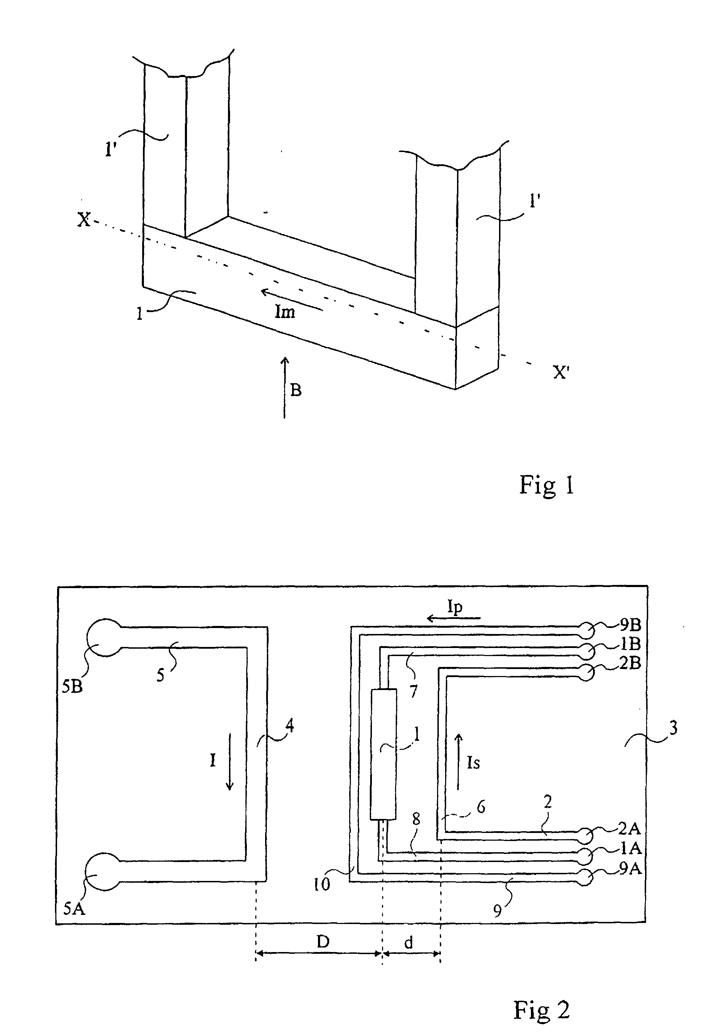

La figure 1 représente une magnétorésistance dite de type HUNT. Une telle magnétorésistance est constituée d'un barreau magnétorésistif 1 réalisé dans un matériau ferromagnétique et taillé parallèlement à l'axe facile d'aimantation du matériau (axe X-X' suivant lequel l'agitation électronique s'oriente naturellement). Les deux extrémités du barreau 1 sont reliées à un conducteur 1' tandis qu'un champ magnétique B est appliqué dans le plan du barreau 1 et perpendiculairement à l'axe X-X' du barreau. Ce champ magnétique B induit une variation de la résistivité entre les extrémités du barreau 1. Si le conducteur 1' est alimenté par un générateur de courant, cette variation de résistivité se traduit par une variation du courant Im qui circule dans le conducteur 1'. Cette variation de résistivité est une fonction simple de la valeur du champ magnétique B.

On connaît un capteur de courant qui utilise une magnétorésistance en couche mince pour mesurer un courant qui circule dans un conducteur. Un tel capteur est, par exemple, décrit dans la demande de brevet européen EP-A-0 300 635. Une magnétorésistance est déposée sur un substrat isolant à proximité d'un conducteur dans lequel circule le courant à mesurer.

Un inconvénient d'un tel capteur est qu'il ne permet pas de déterminer le sens du courant à mesurer lorsque la magnétorésistance est disposée parallèlement au conducteur. En effet, la variation de résistivité est la même pour deux courants de même valeur mais de sens opposé. Un autre inconvénient est que les mesures sont susceptibles d'être faussées par des dérives thermiques de la magnétorésistance. De plus, comme la caractéristique résistance-champ d'une magnétorésistance peut varier d'une magnétorésistance à l'autre dans une fabrication en série, deux capteurs issus d'une même série de fabrication peuvent donner des résultats différents.

Pour déterminer le sens du courant au moyen d'un tel capteur, la magnétorésistance est classiquement placée avec un angle d'environ 45° par rapport au conducteur dans lequel circule le courant à mesurer. La valeur du courant est alors déterminée par une mesure de l'angle entre la direction de la magnétorésistance et la direction du champ magnétique résultant du champ magnétique induit par le courant à mesurer et du champ magnétique induit par un conducteur additionnel dans lequel circule un courant constant et qui est perpendiculaire au conducteur dans lequel circule le courant à mesurer. Le sens du courant peur alors être déduit par une mesure de la résistance de la magnétorésistance. Outre le fait qu'il nécessite la mesure de deux grandeurs (angle et résistance), un tel capteur est peu précis, notamment en raison de phénomènes d'hystérésis engendrés par l'inclinaison de la direction de la magnétorésistance par rapport à la direction du conducteur dans lequel circule le courant à mesurer. De plus, les inconvénients relatifs à la complexité des mesures et à la difficulté de reproductibilité dans une fabrication en série subsistent. En outre, l'apposition d'un conducteur additionnel perpendiculaire au conducteur dans lequel circule le courant à mesurer interdit une réalisation dans le plan du substrat.

La demande de brevet européen EP-A-0 539 081 décrit un capteur de courant circulant dans un conducteur primaire déposé sur une face d'un substrat isolant, comportant en outre une magnétorésistance constituée d'un dépôt ferromagnétique parallèle par rapport au conducteur primaire, et un conducteur de polarisation parallèle par rapport à la magnétorésistance et raccordé à une source de polarisation.

La présente invention vise à pallier les inconvénients mentionnés ci-dessus en proposant un capteur de courant à magnétorésistance qui permette une mesure précise à la fois de la valeur et du sens du courant.

L'invention vise également à ce que cette mesure ne fasse appel qu'à une seule grandeur.

L'invention vise également à rendre la mesure indépendante de dérives thermiques de la magnétorésistance.

L'invention vise également à permettre une bonne reproductibilité des caractéristiques du capteur dans une fabrication en série.

L'invention vise en outre à proposer un capteur qui puisse être réalisé aussi bien dans le plan du substrat que dans son épaisseur.

Pour atteindre ces objets, la présente invention prévoit un capteur de courant tel que défini par la revendication 1. D'autres modes de réalisation particuliers du capteur de courant sont définis par les revendications 2 à 9.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment est destinée à exposer l'état de la technique et le problème posé ;
la figure 2 représente un premier mode de réalisation d'un capteur de courant selon un premier aspect de l'invention ;
la figure 3 représente la caractéristique de la résistance de l'élément magnétorésistif du capteur de courant représenté à la figure 2 ; et
la figure 4 représente un mode de réalisation d'un capteur de courant selon un deuxième aspect de l'invention.

Pour des raisons de clarté, les figures ne sont pas à l'échelle et les mêmes éléments ont été désignés par les mêmes références aux différentes figures.

Un capteur de courant, selon un premier aspect de l'invention tel que représenté à la figure 2, comporte une magnétorésistance 1 réalisée sous la forme d'une couche de matériau ferromagnétique déposée sur un substrat isolant 3. Cette magnétorésistance 1 est déposée parallèlement à un tronçon 4 d'un conducteur primaire 5 dans lequel circule le courant I à mesurer et est placée à une distance D du tronçon 4. Le conducteur primaire 5 est constitué d'une piste conductrice déposée sur la même face du substrat 3 que la magnétorésistance 1 et comporte deux bornes d'entrées SA et 5B du capteur.

Selon un premier mode de réalisation représenté à la figure 2, un conducteur de polarisation 9 de la magnétorésistance 1 est intercalé entre le tronçon 4 du conducteur primaire 5 et la magnétorésistance 1. Ce conducteur de polarisation 9 est constitué d'une piste conductrice déposée sur la même face du substrat 3 que le conducteur primaire 5 et présente, selon l'invention, un tronçon 10 parallèle à la magnétorésistance 1. Le conducteur 9 est relié à un générateur de polarisation (non représenté) par ses deux bornes d'extrémités 9A et 9B. Le générateur de polarisation fournit un courant constant.

Une fonction de ce conducteur de polarisation 9 est de décaler la caractéristique résistance-champ de la magnétorésistance 1 sans la déformer.

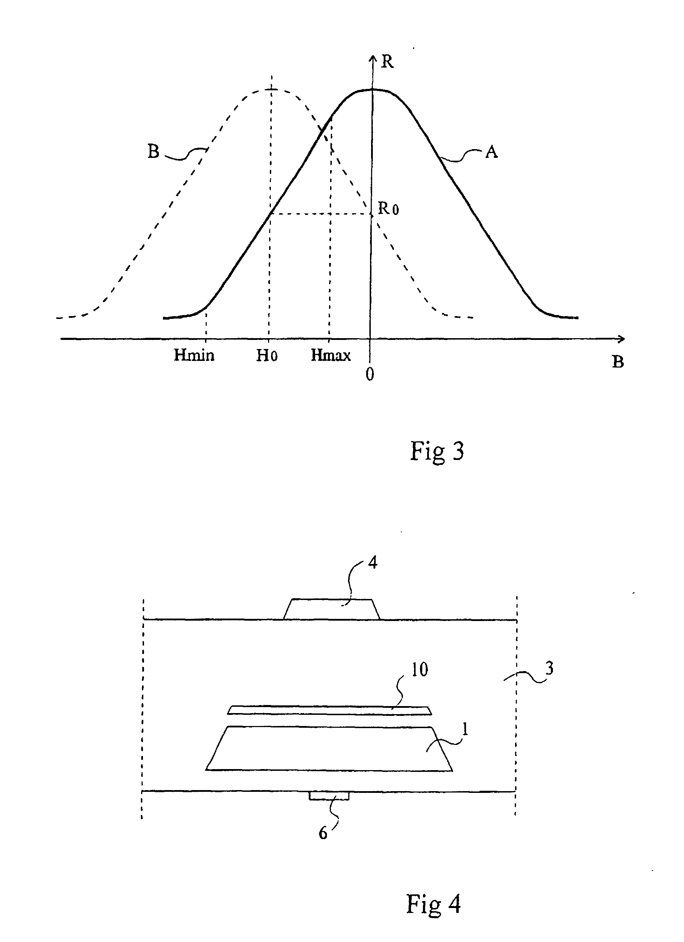

Cette fonction est illustrée par la figure 3. Cette figure 3 montre la caractéristique de la résistance d'une magnétorésistance en fonction du champ magnétique, respectivement en l'absence d'une polarisation de la magnétorésistance 1 (courbe A en traits pleins) et en présence d'un courant de polarisation Ip constant et parallèle à la magnétorésistance (courbe B en pointillés).

Comme on peut le constater, l'effet du courant constant de polarisation Ip est de décaler la caractéristique résistance-champ de la magnétorésistance 1. Le champ magnétique induit par un courant I circulant dans le conducteur 5 modifie alors la résistance R par rapport à une valeur de résistance R0 qui correspond au champ H0 induit par le courant de polarisation constant Ip. On notera que le décalage de la caractéristique résistance-champ de la magnétorésistance 1 peut être effectué dans un sens ou dans l'autre en fonction du sens du courant de polarisation Ip. On notera également que le fait que le tronçon 10 est parallèle à la magnétorésistance 1 permet que le décalage de la caractéristique résistance-champ de la magnétorésistance 1 ne s'accompagne pas d'une déformation de cette caractéristique.

Le fait de décaler la caractéristique résistance-champ de la magnétorésistance rend une partie de cette caractéristique bijective. En d'autres termes, on dispose désormais d'une portion dans laquelle, à une valeur de champ donnée, correspond une seule valeur de résistance R. Cela permet de déterminer, à la fois, le sens et la valeur du courant I à partir de la résistance R. La valeur de la résistance R de la magnétorésistance 1 est égale à R0 pour un courant I nul. En présence d'un courant I non nul, la valeur de la résistance R donne à la fois la valeur du courant I et son sens selon que R est supérieur ou inférieur à R0.

Le fait que le tronçon 10 soit parallèle à la magnétorésistance 1 et au tronçon 4 du conducteur primaire 5 permet de supprimer tout hystérésis et améliore ainsi considérablement les mesures, notamment pour de faibles valeurs de courant à mesurer. On notera qu'un tel agencement parallèle permet également de réaliser le capteur dans le plan du substrat 3.

La valeur Ip du courant de polarisation ainsi que la distance entre le tronçon 10 du conducteur de polarisation 9 et la magnétorésistance 1 sont choisies pour que la réponse résistive de la magnétorésistance 1, en fonction du champ magnétique, soit dans une portion linéaire (par exemple, comprise entre Hmin et Hmax) de sa caractéristique. Le fait de placer la plage de mesure dans une portion linéaire de la caractéristique résistance-champ de la magnétorésistance 1 optimise la précision des mesures et la résolution du capteur. En outre, cette portion linéaire étant de forte pente, notamment grâce à l'agencement en parallèle, on se place dans une zone de la caractéristique où la sensibilité est la meilleure, ce qui confère une sensibilité optimale au capteur.

De préférence, un conducteur secondaire 2 sous forme d'une piste conductrice est également déposé sur cette même face du substrat 3 de l'autre côté de la magnétorésistance 1 par rapport au conducteur primaire 5. Le conducteur secondaire 2 comporte au moins un tronçon 6 qui est parallèle à la magnétorésistance 1, à une distance d de la magnétorésistance 1.

Les deux bornes 2A et 2B du conducteur secondaire 2 sont reliées à un générateur de courant variable (non représenté). Le rôle de ce générateur de courant est de fournir un courant Is qui compense le champ induit par le courant I circulant dans le conducteur primaire 5. Ainsi, lorsque la valeur Is du courant secondaire est telle qu'elle compense le champ induit par le courant I, on peut déduire de la valeur du courant de compensation Is, la valeur du courant I.

En effet, le courant I est alors proportionnel au courant Is, le coefficient de proportionnalité étant fonction des distances D et d qui séparent la magnétorésistance 1 des conducteurs, respectivement primaire 5 et secondaire 2. La relation entre le courant I du conducteur primaire 5 et le courant Is du conducteur secondaire 2, lorsque les champs magnétiques induits par les deux conducteurs 5 et 2 se compensent, est I = Is*D/d.

Pour déterminer la valeur du courant Is pour laquelle le champ induit par le courant I est compensé, c'est-à-dire pour laquelle le champ magnétique dans la magnétorésistance 1 est égal à H0, chaque extrémité de la magnétorésistance 1 est reliée par une piste conductrice 7 et 8 à deux bornes, respectivement 1A et 1B. Ces bornes 1A et 1B sont destinées à être reliées aux bornes d'un voltmètre (non représenté). La tension mesurée aux bornes de la magnétorésistance 1 permet de déterminer la valeur et le sens du courant Is qu'il faut produire pour compenser le champ induit par le courant I. Ainsi, lorsque la tension indiquée par le voltmètre correspond à la tension de repos aux bornes de la magnétorésistance 1 (c'est-à-dire la tension mesurée en l'absence de courant I et de courant Is), la valeur et le sens du courant Is permettent de déterminer la valeur et le sens du courant I. En d'autres termes, on exploite le courant Is lorsque la tension indiquée par le voltmètre correspond au produit du courant de polarisation constant Ip par la valeur de résistance R0.

On pourrait, le cas échéant, se dispenser du conducteur secondaire 2 et utiliser directement la tension aux bornes de la magnétorésistance 1 pour déterminer la valeur du courant I. Dans ce cas, on doit préalablement à toute mesure établir une table de correspondance entre la tension aux bornes de la magnétorésistance 1 et l'intensité du courant I. En effet, on ne dispose alors plus d'une relation pouvant être déduite uniquement des distances D et d, mais d'une relation qui prend en compte, notamment, la caractéristique résistance-champ de la magnétorésistance 1.

On préférera donc avoir recours à un conducteur secondaire 2 car il permet un asservissement de la mesure et rend cette mesure indépendante, à la fois, de variations de la caractéristique résistance-champ d'une magnétorésistance à une autre dans une fabrication en série et de dérives thermiques de la magnétorésistance. Il n'en reste pas moins que, même en l'absence de conducteur secondaire 2, à la fois la valeur et le sens du courant I peuvent être déterminés à partir d'une seule grandeur.

Le choix des distances D et d dépend, notamment, de la plage de fonctionnement en courant du capteur et, en particulier, de l'écart entre les valeurs de courant I à mesurer et la plage de fonctionnement du générateur de courant fournissant le courant Is.

Pour permettre de réduire la plage de fonctionnement du générateur de courant fournissant le courant Is, on peut avoir recours à un conducteur secondaire 2 constitué d'une piste en forme de colimaçon à tronçons rectilignes. On multiplie ainsi la valeur du champ de compensation induit par le courant Is par le nombre de tronçons rectilignes et parallèles du conducteur 2 qui sont proches de la magnétorésistance 1.

La magnétorésistance 1 est constituée d'un matériau ferromagnétique, par exemple de fer/nickel. On peut également prévoir qu'elle soit constituée de fer, de nickel et d'argent, ce qui améliore sa sensibilité.

La réalisation des différents éléments raccordés aux bornes 1A, 1B, 2A, 2B, 9A et 9B de la magnétorésistance 1 et des conducteurs secondaire 2 et de polarisation 9 est fonction de l'application à laquelle est destinée le capteur selon l'invention. On pourra, par exemple, avoir recours à un circuit comportant, notamment, la source de polarisation fournissant le courant Ip et une source de courant de compensation Is commandée en tension, cette tension de commande correspondant à la tension aux bornes 1A et 1B de la magnétorésistance 1.

La figure 4 est une vue en coupe d'un capteur constituant un autre aspect de l'invention. En effet, l'invention prévoit aussi de réaliser le capteur non plus sur une surface d'un substrat isolant mais dans l'épaisseur d'un substrat.

Ainsi, comme le montre la figure 4, le capteur est constitué d'un empilement de couches conductrices dans l'épaisseur du substrat isolant 3. Au moins un tronçon 4 du conducteur primaire est déposé sur une première face du substrat 3 tandis qu'au moins un tronçon 6 du conducteur secondaire est déposé sur une seconde face du substrat 3. Entre les deux, dans l'épaisseur du substrat 3, sont réalisées la magnétorésistance 1 et au moins un tronçon 10 du conducteur de polarisation. En d'autres termes, le capteur est réalisé à partir d'un empilement alternant des couches conductrices 4, 10, 1, 6 et des couches isolantes 3. Bien que cela ne soit pas visible sur la représentation en coupe de la figure 4, tous les tronçons 6, 4 et 10 des conducteurs 2, 5 et 9 sont parallèles entre eux et à la magnétorésistance 1, au moins sur une longueur égale à la longueur de la magnétorésistance 1. De même, bien que les bornes de raccordement des conducteurs 2, 5 et 9 et de la magnétorésistance 1 ne soient pas visibles à la figure 4, le fonctionnement du capteur est similaire à celui représenté à la figure 2. Les distances D et d, qui déterminent le rapport entre le courant à mesurer I et le courant de compensation Is, correspondent désormais à l'épaisseur de substrat isolant 3 qui sépare la magnétorésistance 1, respectivement, du tronçon 4 du conducteur primaire 5 et du tronçon 6 du conducteur secondaire 2.

Le rapport entre les courants primaire et secondaire est donc fixé, dans le mode de réalisation représenté à la figure 4, par la durée de dépôt des matériaux constitutifs de l'empilement et leur usinage, alors que dans le mode de réalisation exposé en relation avec la figure 2, ce rapport est fixé par le procédé, généralement photolithographique, de définition des pistes.

Un avantage d'un capteur plan tel que représenté à la figure 2 est que la distance D entre le tronçon 4 du conducteur primaire 5 et la magnétorésistance 1 peut être plus importante pour un substrat de même nature (par exemple en silicium).

Un avantage d'un capteur empilé tel que représenté à la figure 4 est qu'il offre une meilleure sensibilité. En effet, dans le cas d'un capteur plan, le plan dans lequel s'inscrivent les vecteurs directeurs du champ magnétique induit et du courant dans la magnétorésistance est perpendiculaire au plan de la couche mince constitutive de la magnétorésistance. La magnétorésistance est donc sensible dans son épaisseur (par exemple, de l'ordre de quelques micromètres). Par contre, dans le cas d'un capteur empilé, le plan dans lequel s'inscrivent les vecteurs directeurs est parallèle au plan de la couche constitutive de la magnétorésistance (par exemple, de l'ordre de quelques millimètres), ce qui confère au capteur une plus grande sensibilité. On notera que les vecteurs directeurs du champ magnétique induit par le courant I et du courant dans la magnétorésistance 1 sont toujours perpendiculaires entre eux.

Les couches isolantes 3 (figure 4) peuvent être constituées d'un même matériau ou de matériaux différents. On pourra, par exemple, avoir recours à de l'oxyde de silicium, du verre, ou tout autre matériau isolant. L'emploi du verre permet, notamment, de prévoir des épaisseurs plus importantes qu'avec de l'oxyde de silicium en raison des limites technologiques actuelles. Cela permet d'augmenter le rapport D/d pour mesurer des courants plus importants.

On notera que, comme dans le cas d'un capteur plan, on peut réaliser un capteur empilé dans lequel les conducteurs secondaire et de polarisation sont confondus. Par exemple, l'empilement peut être réalisé en disposant le conducteur secondaire sur une première face d'un substrat de silicium présentant une épaisseur de quelques centaines de micromètres (par exemple 300 µm). La magnétorésistance est réalisé depuis une seconde face de ce substrat et est séparée du conducteur primaire par une épaisseur de verre de l'ordre de quelques millimètres.

Le capteur proposé par la présente invention est de constitution simple, et peu encombrant. L'asservissement réalisé au moyen du conducteur secondaire 2 simplifie en plus la fabrication en série de ce capteur. En outre, le capteur selon l'invention présente une bonne résolution qui autorise des mesures précises même pour de faibles courants tout en pouvant posséder une grande plage de fonctionnement en courant à mesurer.

Bien entendu, la présente invention est susceptible de diverses variantes et modifications qui apparaîtront à l'homme de l'art. En particulier, le dimensionnement des différents conducteurs et de la magnétorésistance est fonction de l'application et, notamment, de la plage de fonctionnement en courant souhaitée pour le capteur.

## Revendications

1. Capteur de courant (I) circulant dans un conducteur primaire (5) déposé sur une première face d'un substrat isolant (3), comportant une magnétorésistance (1) constituée d'un dépôt ferromagnétique en couche mince parallèle à un tronçon (4) du conducteur primaire (5), ainsi qu' un conducteur de polarisation (9) parallèle à la magnétorésistance (1) par un tronçon (10) d'une longueur au moins égale à celle de la magnétorésistance (1) et raccordé, par ses deux extrémités (9A, 9B), aux bornes d'une source de polarisation, **caractérisé en ce que** la source de polarisation fournit un courant constant (Ip) fixé en fonction de la caractéristique résistance-champ de la magnétorésistance (1), ladite magnétorésistance étant raccordée par ses deux extrémités (9A, 9B) à un voltmètre.

2. Capteur de courant selon la revendication 1, **caractérisé en ce qu'**il comporte un conducteur secondaire (2) constitué d'une piste conductrice qui est parallèle à la magnétorésistance (1) par au moins un tronçon (6) distant d'une valeur donnée (d) de la magnétorésistance (1), ledit conducteur secondaire (2) étant raccordé par ses deux extrémités (2A, 2B) aux bornes d'un générateur d'un courant variable (Is) destiné à compenser le champ magnétique induit, dans la magnétorésistance (1), par le courant à mesurer (I).

3. Capteur de courant selon la revendication 2, **caractérisé en ce que** ledit tronçon (4) du conducteur primaire (5) et ledit tronçon (6) du conducteur secondaire (2) sont distants de la magnétorésistance de distances (D, d) déterminées en fonction de la plage de fonctionnement en courant souhaitée pour le capteur.

4. Capteur de courant selon la revendication 2 ou 3, **caractérisé en ce que** ledit tronçon (10) du conducteur de polarisation (9) est intercalé entre la magnétorésistance (1) et ledit tronçon (4) du conducteur primaire (5), la magnétorésistance (1) étant intercalée entre lesdits tronçons (10, 6) des conducteurs de polarisation (9) et secondaire (2).

5. Capteur de courant selon l'une quelconque des revendications 1 à 4, **caractérisé en ce que** lesdits tronçons (4, 10, 6) des conducteurs (5, 9, 2) ainsi que la magnétorésistance (1) sont déposés sur une même face du substrat isolant (3) en étant écartés de distances (D, d) déterminées.

6. Capteur de courant selon l'une quelconque des revendications 1 à 4, **caractérisé en ce que** lesdits tronçons (4, 10, 6) des conducteurs (5, 9, 2) ainsi que la magnétorésistance (1) sont empilés avec interposition de couches de substrat isolant (3) d'épaisseurs déterminées.

7. Capteur de courant selon la revendication 6, **caractérisé en ce que** lesdites couches de substrat isolant (3) sont en des matériaux différents.

8. Capteur de courant selon l'une quelconque des revendications 1 à 7, **caractérisé en ce que** ladite magnétorésistance (1) est constituée d'un dépôt en couche mince de fer/nickel.

9. Capteur de courant selon l'une quelconque des revendications 1 à 7, **caractérisé en ce que** ladite magnétorésistance (1) est constituée d'un dépôt en couche mince de fer/nickel/argent.

## Claims

1. A current sensor of the current (I) flowing in a primary conductor (5) deposited on a first face of an insulating substrate (3), comprising a magnetoresistor (1) formed by a ferromagnetic deposit in a thin layer parallel to a section (4) of the primary conductor (5), and a polarisation conductor (9) parallel to the magnetoresistor (1) by a section (10) with a length at least equal to that of the magnetoresistor (1) and connected via its two ends (9A, 9B) to the terminals of a polarisation source, **characterized in that** the polarisation source supplies a constant current (Ip) fixed according to the resistance-field characteristic of the magnetoresistor (1), said magnetoresistor being connected via its two ends (9A, 9B) to a voltmeter.

2. The current sensor according to claim 1, **characterized in that** it comprises a secondary conductor (2) formed by a conducting track which is parallel to the magnetoresistor (1) by at least one section (6) distant from the magnetoresistor (1) by a given value (d), said secondary conductor (2) being connected via its two ends (2A, 2B) to the terminals of a variable current generator (Is) designed to compensate the magnetic field induced in the magnetoresistor (1) by the current to be measured (I).

3. The current sensor according to claim 2, **characterized in that** said section (4) of the primary conductor (5) and said section (6) of the secondary conductor (2) are distant from the magnetoresistor by distances (D, d) determined according to the current operating range required for the sensor.

4. The current sensor according to claim 2 or 3, **characterized in that** said section (10) of the polarisation conductor (9) is inserted between the magnetoresistor (1) and said section (4) of the primary conductor (5), the magnetoresistor (1) being inserted between said sections (10, 6) of the polarisation conductor (9) and the secondary conductor (2).

5. The current sensor according to any one of the claims 1 to 4, **characterized in that** said sections (4, 10, 6) of the conductors (5, 9, 2) and the magnetoresistor (1) are deposited on one and the same face of the insulating substrate (3) and are separated by preset distances (D, d).

6. The current sensor according to any one of the claims 1 to 4, **characterized in that** said sections (4, 10, 6) of the conductors (5, 9, 2) and the magnetoresistor (1) are stacked with interposition of layers of insulating substrate (3) of preset thicknesses.

7. The current sensor according to claim 6, **characterized in that** said layers of insulating substrate (3) are made of different materials.

8. The current sensor according to any one of the claims 1 to 7, **characterized in that** said magnetoresistor (1) is formed by a deposit of iron/nickel in a thin layer.

9. The current sensor according to any one of the claims 1 to 7, **characterized in that** said magnetoresistor (1) is formed by a deposit of iron/nickel/silver in a thin layer.

## Patentansprüche

1. Stromsensor zur Messung des Stroms (I) in einem auf eine erste Seite eines Isolierstoffträgers aufgebrachten Primärleiter (5), welcher Sensor einen magnetfeldabhängigen Widerstand (1), der als auf den Träger aufgebrachte, parallel zu einem Abschnitt (4) des Primärleiters (5) angeordnete dünne ferromagnetische Schicht ausgebildet ist, sowie einen Polarisationsleiter (9) umfaßt, der in einem Teilabschnitt (10), dessen Länge mindestens der Länge des magnetfeldabhängigen Widerstands (1) entspricht, parallel zum magnetfeldabhängigen Widerstand (1) verläuft und mit seinen beiden Enden (9A, 9B) an die Klemmen einer Polarisationsspannungsquelle angeschlossen ist, **dadurch gekennzeichnet, daß** die Polarisationsspannungsquelle einen konstanten Strom (Ip) liefert, der in Abhängigkeit vom Widerstandsverlauf des magnetfeldabhängigen Widerstands (1) festgelegt wird, wobei der genannte magnetfeldabhängige Widerstand mit seinen beiden Enden (2A 2B) an ein Voltmeter angeschlossen ist.

2. Stromsensor nach Anspruch 1, **dadurch gekennzeichnet, daß** er einen Sekundärleiter (2) in Form einer Leiterbahn umfaßt, die zumindest mit einem Teilabschnitt (6) in einem festgelegten Abstand (d) parallel zum magnetfeldabhängigen Widerstand (1) verläuft, wobei der genannte Sekundärleiter (2) mit seinen beiden Enden (2A, 2B) an die Klemmen einer Spannungsquelle angeschlossen ist, die einen variablen Strom (Is) erzeugt, welcher dazu dient, das durch den zu messenden Strom (I) im magnetfeldabhängigen Widerstand (1) induzierte Magnetfeld zu kompensieren.

3. Stromsensor nach Anspruch 2, **dadurch gekennzeichnet, daß** der genannte Teilabschnitt (4) des Primärleiters (5) und der genannte Teilabschnitt (6) des Sekundärleiters (2) jeweils in einem bestimmten, vom gewünschten Strommeßbereich des Sensors abhängigen Abstand (D, d) vom magnetfeldabhängigen Widerstand (1) angeordnet sind.

4. Stromsensor nach Anspruch 2 oder 3, **dadurch gekennzeichnet, daß** der genannte Teilabschnitt (10) des Polarisationsleiters (9) zwischen dem magnetfeldabhängigen Widerstand (1) und dem genannten Teilabschnitt (4) des Primärleiters (5) und daß der magnetfeldabhängige Widerstand (1) zwischen den genannten Teilabschnitten (10, 6) des Polarisationsleiters (9) und des Sekundärleiters (2) angeordnet ist.

5. Stromsensor nach irgendeinem der Ansprüche 1 bis 4, **dadurch gekennzeichnet, daß** die genannten Teilabschnitte (4, 10, 6) der Leiter (5, 9, 12) sowie der magnetfeldabhängige Widerstand auf die gleiche Seite des Isolierstoffträgers (3) aufgebracht und in bestimmten Abständen (D, d) zueinander angeordnet sind.

6. Stromsensor nach irgendeinem der Ansprüche 1 bis 4, **dadurch gekennzeichnet, daß** die genannten Teilabschnitte (4, 10, 6) der Leiter (5, 9, 12) und der magnetfeldabhängige Widerstand (1) übereinander angeordnet und zwischen ihnen einzelne Schichten des Isolierstoffträgers (3) mit bestimmter Dicke ausgebildet sind.

7. Stromsensor nach Anspruch 6, **dadurch gekennzeichnet, daß** die genannten Schichten des Isolierstoffträgers (3) aus unterschiedlichen Materialien bestehen.

8. Stromsensor nach irgendeinem der Ansprüche 1 bis 7, **dadurch gekennzeichnet, daß** der genannte magnetfeldabhängige Widerstand (1) aus einer auf den Träger aufgebrachten dünnen Eisen-Nickel-Schicht besteht.

9. Stromsensor nach irgendeinem der Ansprüche 1 bis 7, **dadurch gekennzeichnet, daß** der genannte magnetfeldabhängige Widerstand (1) aus einer auf den Träger aufgebrachten dünnen Eisen-Nickel-Silber-Schicht besteht.
